# DEMANDE DE BREVET EUROPEEN

(11) **EP 2 731 058 A1**
(43) Date de publication de la demande: **14.05.2014**
(21) Numéro de dépôt: 12306399.2
(22) Date de dépôt: 13.11.2012
(51) Int. Cl.: G06K 19/077, H01L 23/60

(54) **Procédé de fabrication d'un module à puce électronique anti-charge électrostatique**

(71) Demandeur: Gemalto SA, 92190 Meudon (FR)
(72) Inventeur: Ottobon, Stéphane, 83270 SAINT CYR SUR MER (FR)

(57) **Abrégé**

L'invention concerne un procédé de fabrication d'un module (1) à puce de circuit intégré (électronique) comprenant les étapes suivantes :
- réalisation de piste ou plage conductrice (2, GND) sur un support isolant (3) comportant au moins une perforation à travers le support isolant en regard d'au moins une plage de contact de masse (GND),
- fixation d'une puce de circuit intégré (4) sur le module à l'aide d'une colle conductrice, ladite colle s'étendant dans ladite perforation (E, 17) et reliant ladite plage de contact de masse (GND) avec une surface de la puce ;

Le procédé se distingue en ce qu'il comprend les étapes suivantes :
- de réalisation de ladite perforation (E, 17) d'une dimension inférieure à une surface principale (S) de la puce,
- et de report de la puce sur le support isolant.

L'invention concerne également un objet à puce de circuit intégré comprenant le module obtenu par le procédé.

## Description

### Domaine de l'invention.

L'invention concerne un procédé de fabrication d'un module à puce de circuit intégré (ou puce électronique) protégé contre les charges électrostatiques ainsi que le module obtenu.

L'invention concerne particulièrement les cartes à puce de circuit intégré à contacts électriques ; mais elle peut concerner notamment d'autres supports électroniques tels que des passeports électroniques, cartes sans contact ou cartes hybrides, tickets ou étiquettes radiofréquences, transpondeurs radiofréquences, inserts (ou inlay) intégrant ou constituant un tel module.

De tels objets peuvent être conformes notamment au standard ISO 78016 et/ ou ISO / IEC 14443, ou concerner des clés de communication notamment de type USB.

### Art antérieur.

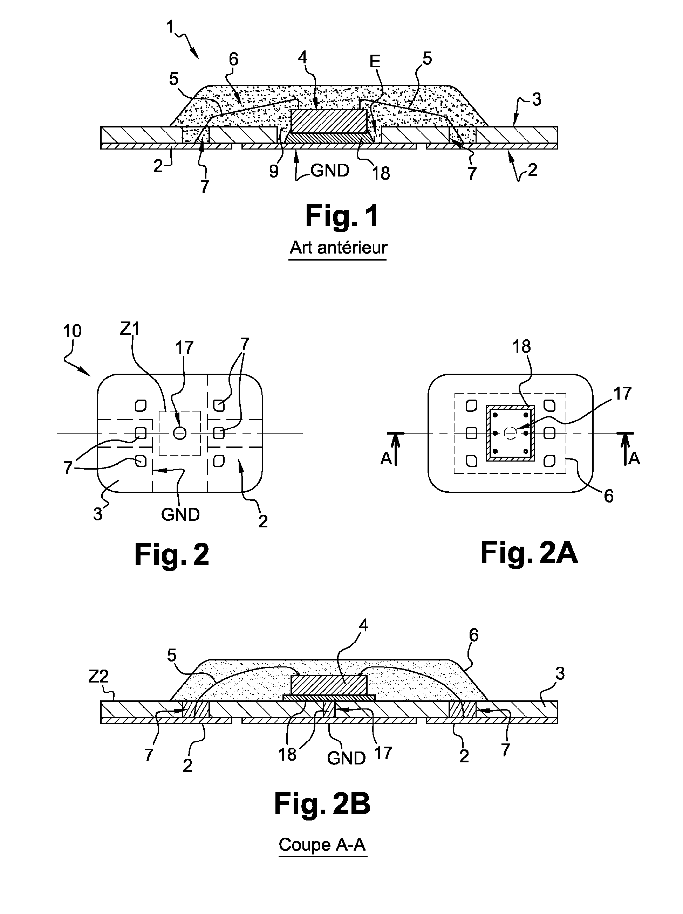

Il est connu de fabriquer un module de carte à puce (illustré à la figure 1) par les étapes suivantes :
- réalisation de plages conductrices sur un support isolant comportant au moins une perforation à travers le support isolant en regard d'au moins une plage de contact pour la masse,
- fixation d'une puce de circuit intégré sur le module à l'aide d'une colle conductrice s'étendant dans la perforation et reliant la plage de contact pour la masse et une surface arrière de la puce.

### Problème technique.

Les fabricants de carte à puce sont de plus en plus confrontés à un problème d'écriture et d'effacement de bits de mémoire « flash » rendant la carte non personnalisable et donc non fonctionnelle du fait de la forte croissance des technologies « fines de semiconducteur » (gravure, ..) de puce qui font que leur sensibilité à une tension limite, à l'ESD et aux charges est fortement augmentée. Ce problème apparait lorsque les charges mobiles dans la puce ne sont pas ou mal évacuées car un module sans fenêtre et dans lequel la puce n'est pas collée avec une colle conductrice est utilisé.

Une alternative possible mais non satisfaisante pour certains produits ou applications finales est d'utiliser un module avec une fenêtre ayant au moins la dimension d'une puce (fig. 1) et dans laquelle la puce est collée avec une colle conductrice. Mais cette solution présente des inconvénients pour plusieurs raisons expliquées plus loin et n'est pas possible dans tous les cas.

Cette solution actuelle présente plusieurs inconvénients ci-après. Le plus important est qu'un tel module est beaucoup moins fiable mécaniquement qu'un module sans fenêtre (par exemple au test des 3 galets ou au test de pression sur module,...). Ceci se comprend aisément car dans le cas d'un module avec fenêtre, la puce est très proche des sollicitations extérieures étant collée directement sur le cuivre de la face contact du module. Cette solution ne peut donc pas être utilisée pour certains clients et applications pour lesquels une haute tenue mécanique est exigée.

Un module avec fenêtre limite la taille des puces qu'on peut intégrer dans le module Un module avec fenêtre peut est plus cher car il y a une grande surface à métalliser de métaux nobles comme le nickel (Ni) ou l'or (Au).

Aujourd'hui, il n'existe pas de solution qui garantisse une haute fiabilité d'un module sans fenêtre et qui résolve le problème d'évacuation des charges mobiles de la puce.

Le problème ci-dessus est identifié par les inventeurs. L'invention a donc pour objectif de concevoir un procédé de fabrication d'un module qui réponde au double problème exposé ci-dessus d'un module protégé contre les décharges électrostatique et très résistant / fiable mécaniquement.

### Résumé de l'invention.

L'invention décrite ci-dessous résout ces deux objectifs antagonistes par une conception particulière du module :
Elle vise à concevoir un module à puce de circuit intégré (ou à puce électronique) dont la configuration permet d'être très fiable mécaniquement (du fait des tests mécaniques sévères à tenir) tout en permettant l'évacuation des charges mobiles des puces.
Ces charges mobiles lorsqu'elles s'accumulent et ne sont pas évacuées sont de plus en plus un problème du fait des nouvelles technologies de puce électronique (mémoire de type flash) utilisées par les fondeurs. Ces mémoires sont de plus sensibles du fait notamment de la miniaturisation engendrant de plus en plus petites dimensions d'isolants dans la partie mémoire flash de ces circuits intégrés. La conception d'un module permettant d'évacuer les charges mobiles solutionnerait des problèmes d'écritures et d'effacement de la zone mémoire des puces ou autres problèmes de claquage d'isolants.

L'invention consiste à réaliser un module dans lequel la puce électronique est collée sur le diélectrique, sa présence et sa nature (par ex composite de verre / époxy) permet la résistance du module et la protection de la et ce diélectrique est percé partiellement pour permettre à la colle argent conductrice de fluer jusqu'au cuivre du coeur de la face contact qui est à la masse. Ainsi les charges mobiles contenues dans la puce sont évacuées à travers le canal de la colle conductrice jusqu'au cuivre relié à la masse.

Ces perforations sont réalisées par le fournisseur de film support de plages de contact « leadframe » en même temps que les perforations qui permettent les connexions des fils or aux contacts externes du module.

Ces perforations peuvent être unique ou multiples afin de mieux repartir l'évacuation des charges et de tailles plus ou moins grandes.

Dans tous les cas, chaque perforation se différencie d'une fenêtre car elle est de taille nettement inférieure à la taille de la puce.

L'invention a donc pour objet un procédé de fabrication d'un module à puce de circuit intégré (ou électronique) conforme à la revendication 1.

D'autres caractéristiques et mode de mise en oeuvre font l'objet des revendications 2 à 3.

L'invention a également pour objet un module correspondant au procédé et un objet à puce électronique comportant ce module.

Ainsi, le module conserve sa capacité de résistance mécanique tout en offrant une configuration qui permet l'évacuation des charges électrostatiques et qui préserve les puces notamment les puces à mémoire « flash ».

L'objet peut constituer de préférence un passeport, un livret. Dans le cas d'un module à antenne, cette dernière peut être portée par une feuille ou une couverture du livret ou du passeport.

### Brève description des figures.

- La figure 1 illustre en coupe transversale un module à puce électronique de l'art antérieur ;
- La figure 2 est une vue de dessous d'un support à interface électrique obtenu selon un premier mode de mise en oeuvre du procédé de l'invention ;
- La figure 2A illustre le module de la figure 2, avec la puce fixée sur le support à interface électrique et la protection mécanique de la puce ;
- La figure 2B illustre une vue en coupe selon A-A de la figure 2A ;
- La figure 3 est un module obtenu selon un second mode de mise en oeuvre du procédé ;
- La figure 3A illustre le module de la figure 3, avec la puce fixée sur le support à interface électrique ;
- La figure 3B illustre le module de la figure 3A avec sa protection mécanique ;
- La figure 4A illustre un module similaire à la figure 3A en perspective.

### Description.

La figure 1 illustre un module à puce de circuit intégré 1 de l'art antérieur. Il comprend des pistes ou plages conductrices 2 sur un support 3 diélectrique ou isolant notamment du type LFCC (Lead frame contrecollé), au moins une puce de circuit intégré 4 reportée sur le support ou des plages de contact 2. Ici, la puce est reportée sur une plage correspondant à la masse GND. Il comprend également des connexions 5 notamment par fil soudé ou par colle conductrice, la puce pouvant être retournée (flip-chip) ou non, un enrobage 6 de la puce et/ou de ses connexions par une matière de protection telle une résine (glob-top). Des orifices 7 dans le support 3 permettent de connecter les pistes ou plages conductrices à travers les orifices.

D'après cet art antérieur, le procédé de fabrication d'un module (1) comprend l'étape de réalisation des pistes ou plages conductrices 2, GND sur le support isolant 3 comme précédemment ; Il comprend selon ce mode un évidement E à travers le support isolant 3 en regard de la plage de contact GND destinée à connecter la masse d'un lecteur à contact électrique.

L'évidement E est réalisé avec une dimension permettant de recevoir la puce 4 en partie dedans. La surface de l'évidement est donc au moins supérieure ou égale à celle d'une face principale de la puce.

La puce est collée contre la plage de masse avec une colle conductrice 18 : elle est fixée sur le module, contre la plage de contact GND à l'aide de la colle conductrice 18 ; la colle s'étend dans la perforation sur la plage de contact et relie une surface principale inférieure de la puce, ici la face arrière, à la plage de contact de masse.

Sur les figures 2, 2A, 2B, est illustré un module conforme à un mode de réalisation / mise en oeuvre.

Selon une caractéristique de ce mode, le procédé comprend les étapes de réalisation d'un film support isolant comportant au moins une perforation 17 (ou un via) d'une dimension inférieure à la surface arrière de la puce électronique (ou de circuit intégré);
La colle conductrice est reportée sur la même surface de report que précédemment tout en pénétrant dans la perforation 17 pour contacter la plage de contact de masse GND ; la colle repose ici à la fois dans la perforation et sur le film support dans la zone de report/ collage de la puce. La puce est ensuite reportée sur le support isolant ; Elle repose principalement sur le film support tout en ayant sa face arrière en liaison électrique avec la plage de contact GND.
La puce est sensiblement située au niveau de la face du film support opposée à celle portant les plages de contacts de connexion physique à des connecteurs d'un terminal.

De préférence, la perforation est nettement inférieure à la surface nécessaire pour recevoir une puce. En principe, une surface arrière de puce est de l'ordre de 2x2 mm² voire 0,5 x 0,5 mm². Cependant, des puces plus sophistiquées peuvent avoir une surface pouvant être environ de 4 x 4 mm² ou 5x5 mm².

Grâce à une perforation plus fine que l'évidement, l'invention permet de maintenir plus de matière et de rigidité du film support à interface électrique. Le film support n'est pas ou très faiblement altéré sur le plan de sa résistance mécanique.

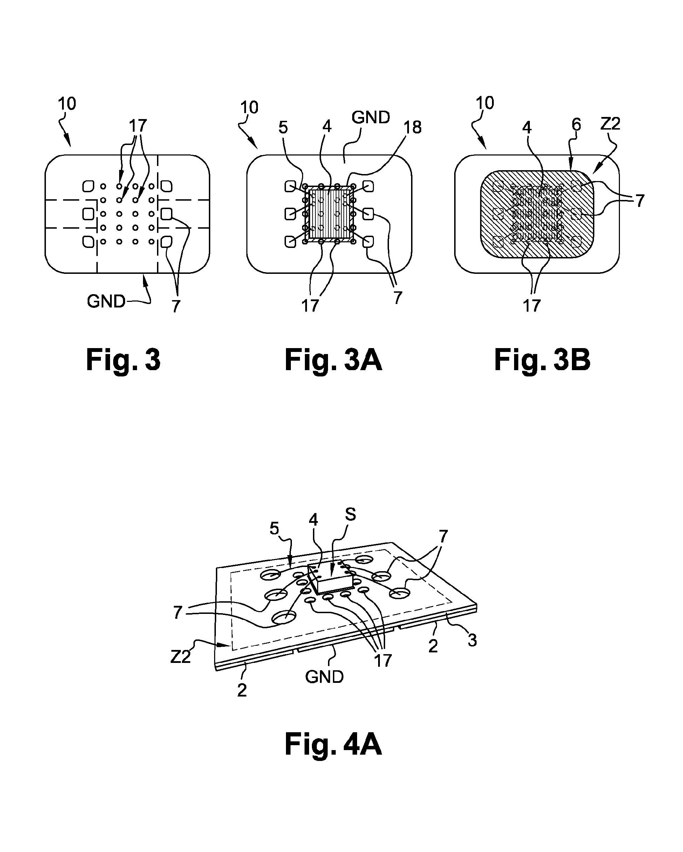

Selon un autre mode de réalisation, illustré aux figures 3, 3A, 3B et 4A, l'invention prévoit de réaliser le module comme précédemment à la différence près que l'on réalise une pluralité de perforations 17 dans le support isolant au lieu d'une seule perforation, dans la zone de report Z1 de la puce (fig. 2). Cette zone est ici située dans une zone sensiblement centrale du module. Cette zone est entièrement recouverte de colle conductrice ; La colle conductrice pénètre dans la plupart des perforations pour contacter la plage de masse. Chaque perforation est ici également d'une surface inférieure à une surface principale S de la puce (fig. 4A).

Le module comprend également une zone Z2 de collage du module dans une cavité de corps de carte à puce ; elle est située en périphérie de la protection 6 pouvant être réalisée notamment en résine (dispensée ou surmoulée) ou par un capot de protection.

Ainsi, il y a une bonne répartition des évacuations de charges de la puce sur toute la zone de report de la puce.

La résistance mécanique du film support est peu affectée car la matière de film support enlevée par les perforations est compensée au moins en partie par la colle conductrice.

Alternativement, l'invention peut prévoir de disposer des perforations (non illustrées) seulement en périphérie d'une zone Z1 correspondant sensiblement à la surface arrière de la puce ou la zone de report de la puce.

Ainsi, les charges venant des parois latérales, peuvent s'évacuer mieux qu'avec une seule perforation centrale. L'avantage est de moins fragiliser le support isolant tout en disposant des évacuations de charges au plus près de l'endroit où elles apparaissent sur la tranche de la puce ou sur la surface avant de la puce.

De manière avantageuse, on réalise la ou les perforations en même temps que celles 7 donnant accès aux différentes plages de contact 2 et qui permettent une connexion, notamment par fil soudé, de la puce à travers l'isolant 3 via les perforations.

Ces perforations peuvent être identiques à celles destinées à contenir de la colle conductrice d'évacuation de charges électrostatiques.

Dans l'exemple, ces perforations peuvent avoir un diamètre compris entre 0,3 et 1 mm ; La surface individuelle de chaque perforation peut être comprise entre 0,07 mm² et 0,8 mm² ; L'invention prévoit de préférence d'occuper environ un tiers de la surface de report de la puce par des perforations espacées d'environ une à deux fois le diamètre d'une perforation. Ce ratio correspondant à St (surface trou(s)) = environ 1/3 Sp (Surface Puce) est un ratio préféré optimal pour garder une bonne tenue mécanique du film support isolant (Leadframe) perforé et bien évacuer les charges mobiles.

La surface totale de la ou des perforations est donc de préférence inférieure à environ 66 %. Le cas échéant, si le film support a une bonne résistance, le taux ci-dessus peut être porté à 80 % de la surface principale (S) de la puce.

Plutôt que d'être à l'aplomb de la puce, la perforation 17 peut être décalée par rapport à la zone de report Z1 ou surface principale S de la puce ; La matière conductrice peut s'étendre de la puce jusqu'à cette perforation située légèrement en dehors de la zone Z1.

Selon une variante de réalisation, on réalise des perforations par exemple, juste au niveau des angles de la puce sensiblement à l'aplomb des arêtes de la puce.

On peut observer que les perforations peuvent être d'une section de préférence inférieure à celle des perforations 7 destinées aux connexions filaires de la puce.

Le procédé de l'invention peut contribuer à l'obtention de tout objet portable électronique comportant le transpondeur ou module décrit ci-dessus.

## Revendications

1. Procédé de fabrication d'un module (1) à puce de circuit intégré comprenant les étapes suivantes :
- réalisation de piste ou plage conductrice (2, GND) sur un support isolant (3) comportant au moins une perforation à travers le support isolant en regard d'au moins une plage de contact de masse (GND),
- fixation d'une puce de circuit intégré (4) sur le module à l'aide d'une colle conductrice, ladite colle s'étendant dans ladite perforation (E, 17) et reliant ladite plage de contact de masse (GND) avec une surface de la puce,
**caractérisé en ce qu'il** comprend les étapes suivantes :
- de réalisation de ladite perforation (E, 17) d'une dimension inférieure à une surface principale (S) de la puce,
- et de report de la puce sur le support isolant.

2. Procédé selon la revendication précédente, **caractérisé en ce qu'il** comprend une étape de réalisation d'une pluralité de perforations (17) dans une zone de report de la puce sur le support isolant (3).

3. Procédé selon l'une quelconque des revendications précédentes, **caractérisé en ce que** la perforation (17) est réalisée en même temps que des perforations (7) donnant accès aux différentes plages de contact à connecter par fil soudé.

4. Module (1) à puce de circuit intégré comprenant :
- des pistes ou plage conductrice (2) sur un support isolant (3) comportant au moins une perforation (E, 17) à travers le support isolant en regard d'au moins une plage de contact de masse (GND),
- une puce de circuit intégré (4) fixée sur le module à l'aide d'une colle conductrice, ladite colle s'étendant dans ladite perforation et reliant ladite plage de contact de masse et une surface de la puce,
**caractérisé en ce que** :
- ledit film support (3) comprend au moins une perforation (17) d'une surface inférieure à la surface principale (S) de la puce (4),
- et de report de la puce sur le support isolant.

5. Module (1) à puce de circuit intégré selon la revendication précédente, **caractérisé en ce que** la surface totale de la ou des perforations est au moins inférieure à environ 80 % de la surface principale (S) de la puce.

6. Module (1) à puce de circuit intégré selon la revendication précédente, **caractérisé en ce que** ladite perforation (17) est décalée par rapport à la zone de report de la puce, la matière conductrice s'étendant de la puce jusqu'à cette perforation.

7. Objet à puce de circuit intégré tel qu'une carte, un jeton, une clé de communication comprenant le module obtenu selon ou conforme à l'une des revendications 4 à 6.
